# EUROPEAN PATENT SPECIFICATION

(11) **EP 0 959 566 B1**
(45) Date of publication and mention of the grant of the patent: **02.04.2003**
(21) Application number: 98109342.0
(22) Date of filing: 22.05.1998
(51) Int. Cl.: H03M 1/06

(54) **Digital to analog conversion apparatus and method**
Gerät und Verfahren zur Digital-Analog-Wandlung
Dispositif et procédé pour la conversion numérique-analogique

(43) Date of publication of application: 24.11.1999
(73) Proprietor: MOTOROLA, INC., Schaumburg, IL 60196-1065 (US)
(72) Inventor: Koifman, Vladimir, 52542 Ramat Gan (IL); Afek, Yachin, 44257 Kfar Saba (IL)
(74) Representative: Gibson, Sarah Jane

(56) References cited:
- EP-A- 0 704 978
- NORSWORTHY, S.R. ET AL (ED): "Delta-Sigma Data Converters, Theory, Design, and Simulation", Section 8.3.3, pages 251-264" 1997 , IEEE PRESS , NY, USA XP002082100 * page 260, paragraph 8.3.3.4 - page 264, line 2; figure 8.12 *

## Description

### Field of the Invention

The invention concerns a digital to analog conversion apparatus and method.

### Background of the Invention

Digital to Analog Converters (i.e.-DAC) contain a set of current or voltage sources (i.e.- analog elements). Because of manufacturing limitations, the elements differ in their analog output. In spite of the differences, there is a need to provide very accurate, multi-bit digital to analog conversion apparatus and method, having a high signal to noise ratio (i.e.- SNR).

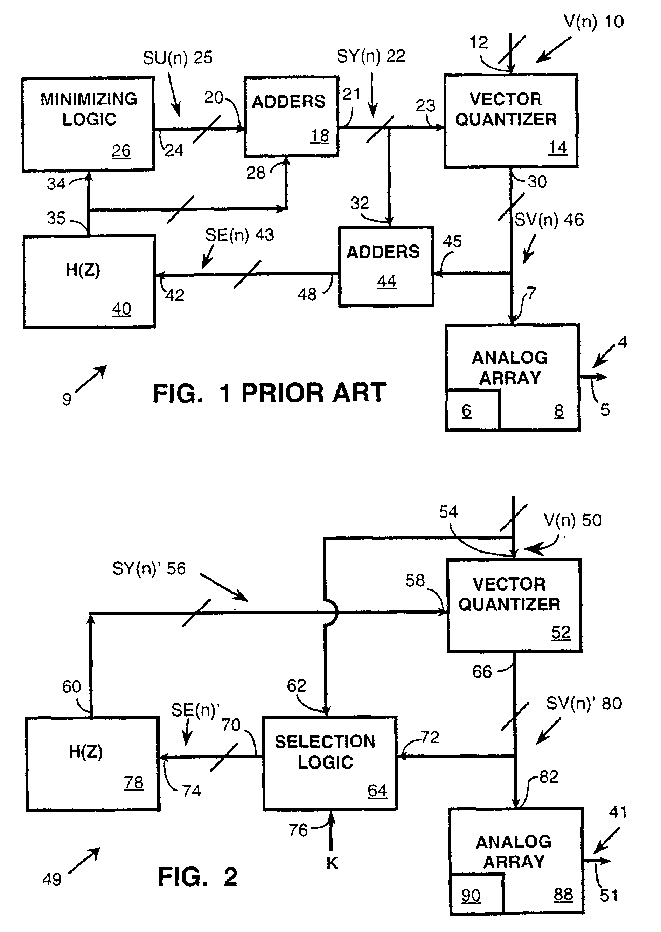

Norsworthy, Schreier and Temes (Norsworthy, Schreier, Temes, "Delta-Sigma Data Converters", IEEE Press, pg. 262-264) describe a dynamic matching engine having high-order noise shape (see FIG. 1). DAC 9 contains vector quantizer 14, M noise shaping elements (i.e. - H(z)) 40, first set of M adders (i.e.- first adders) 44, second set of M adders (i.e.- second adders) 18 and minimizing logic 26. DAC 9 is connected to analog array 8, having M inputs 7, one output 5 and M analog elements 6.

Vector quantizer 14 has M-bit input 12, PxM-bit input 23, and M-bit output 30. P is the number of output bits of each of M noise shaping elements 40. First set of adders 44 has M-bit input 45, PxM-bit input 32 and PxM bit output 48. Noise shaping elements 40 have PxM-bit input 42 and PxM-bit output 35. Minimizing logic 26 has PxM-bit input 34 and PxM-bit output 24. Second adders 18 have two PxM-bit inputs 20, 28 and PxM-bit output 21.

Output 30 of the vector quantizer 14 is coupled to input 45 of first adders 44. Input 32 of first adders 44 is coupled to output 21 of second adders 18. Output 48 of first adders 44 is coupled to input 42 of noise shaping elements 40. Output 35 of noise shaping elements 40 is coupled to input 34 of minimizing logic 26 and to input 28 of second adders 18. Output 24 of minimizing logic 26 is coupled to input 20 of second adders 18. Output 21 of second adders 18 is coupled to input 23 of vector quantizer 14 and to input 32 of first adders 44.

Input 12 of vector quantizer 14 receives input digital vector V(n) 10. Vector V(n) 10 is an M-bit digital vector which has integer values in the range from 0 to M. M-bit digital vector V(n) 10 and PxM-bit vector SY(n) 22 produced by second set of adders 18 are provided to inputs 12, 23, respectively, of vector quantizer 14. Vector quantizer 14 provides M-bit selection vector SV(n) 46 that selects J out of M noise shaping elements 40 that have the highest SY(n) 22 values.

Selection vector SV(n) 46 is sent to input 7 of analog array 8, and input 45 of first adders 44, Vector SY(n) 22 is sent to input 23 of vector quantizer 14 and to input 32 of first adders 44. SV(n) 46 and SY(n) 22 are combined in first adders 44 to produce MxM-bit difference vector SE(n) 43 which is sent to input 42 of noise shaping elements 40. M noise shaping elements 40 can be of first-order shaping or a higher order shaping. Output 35 of noise shaping elements 40 is coupled to input 34 of minimizer logic 26 and input 28 of second adders 18. Minimizer logic 26 finds the smallest value SU(n) 25 of the M outputs of noise shaping elements 40 and second adders 18 subtract SU(n) 25 from all M outputs of noise shaping elements H(z) 40 to provide SY(n) 22. This reduction is done in order to maintain the stability of the matching machine. The subtraction results in PxM-bit vector SY(n) 22 feeding into vector quantizer 14 and to first adders 44.

M-bit selection vector SV(n) 46 produced by vector quantizer 14 activates the respective J out of M analog elements 6 of analog array 8 corresponding to the largest SY(n) 22 values, to provide desired analog output signal 4 on analog array output 5. Analog output signal 4 is the combination of the output of the J activated analog elements 6 in analog array 8.

While this and other prior art are useful, they suffer from several limitations or disadvantages , such as for example, lower than desired SNR, and excessive circuit complexity which adversely affects performance and cost. For example, minimizing logic 26 is quite complex, because it has to find the smallest P-bit vector, out of M vectors, for each clock cycle at the oversampling rate. Therefore, there is a continuing need for an improved digital to analog conversion apparatus and method.

### SUMMARY OF THE INVENTION

The underlying problem of the invention is solved basically by applying the features laid down in the independent claims. Preferred embodiments are given in the dependent claims.

An advantage of the present invention is that it provides a cost efficient, high accuracy digital to analog conversion apparatus and method, with high SNR, and without a complex minimizing circuit.

### BRIEF DESCRIPTION OF THE DRAWINGS

FIG. 1 is a simplified schematic diagram of a DAC according to the prior art; and
FIG. 2 is a simplified schematic diagram of a DAC configured in accordance with the invention;
FIG. 3 is a schematic diagram of a DAC configured in accordance with the invention and showing additional details; and
FIG. 4 is a flow diagram of a method for digital to analog conversion, according to a preferred embodiment of the present invention.

### DETAILED DESCRIPTION OF THE DRAWINGS

FIG. 2 is a simplified schematic diagram of DAC 49 according to the present invention. DAC 49 comprises: vector quantizer 52 analogous to vector quantizer 14 of FIG. 1, M noise shaping elements H(z) 78 analogous to noise shaping elements 40 of FIG. 1, selection logic 64, and analog array 88 with analog elements 90 equivalent in function to analog array 8 and elements 6 of FIG. 1. Analog array 88 has M-bit input 82 and one output 51 on which appears analog output signal 41.

Vector quantizer 52 has PxM-bit input 58, M-bit input 54 and M-bit output 66. Selection logic 64 has two M-bit inputs 72, 62, one NxM-bit output 70 and further inputs 76 for receiving constants R and Q. N is the number of bits of constants R or Q. Preferably, N = M. Preferably, R = K, Q = 0, and just one input 76 is conveniently provided for the constant K, as shown in FIG. 2. Noise shaping elements 78 have NxM-bit input 74 and PxM-bit output 60. Output 66 of vector quantizer 52 is coupled to input 72 of selection logic 62 and to M-bit input 82 of analog array 88. Output 70 of selection logic 64 is coupled to NxM-bit input 74 of noise shaping elements 78. PxM-bit output 60 of noise shaping elements 78 is coupled to PxM-bit input 58 of vector quantizer 52.

When the first input vector 50, V(n) = V(1), enters DAC 49, it is provided to input 54 of vector quantizer 52 and to input 62 of selection logic 64. Input vector V(1) 50 takes on values from 0 to M. The value of V(1) is an integer denoted as L(1). Vector quantizer 52 receives input vector V(1) 50 at input 54 and vector SY'(1) 56 at input 58. Vector SY'(1) is comprised of the MxP-bit output signals of M noise shaping element 78. Vector quantizer 52 selects the L(1) noise shaping elements that provide the highest output signal value for input vector V(1).

Vector quantizer 52 selects the L(n) noise shaping elements that provide the highest output signals. The respective L(n) noise shaping elements are represented by M-bit selection vector SV(n)' 80. Selection vector SV(n) 80 is provided by vector quantizer 52 to analog array 88, resulting in activating L(n) respective analog elements 90. Analog output signal 41 is delivered to output 51 of analog array 88.

Those skilled in the art will appreciate that if H(z) has a bandwidth ranging from Z1 + dZ to Z1 - dZ (for example, Z1 = 0 for bandwidth around DC), then if H(Z1/2) > 0 vector quantizer 52 selects the L(n) noise shaping elements that provide the highest output signal. And if H(Z1/2) < then vector quantizer 52 selects the L(n) noise shaping elements that provide the lowest output signal.

Selection logic 64 receives the vector SV'(n) from output 66 of vector quantizer 52, and stores it. At the next cycle (i.e.- when a new input vector V(n+1)' appears), the stored SV'(n) causes the input signal to the L(n-1) previously chosen noise shaping elements to equal V(n) - R, and the input signal to the M - L(n-1) other noise shaping elements to equal V(n) - Q. Conveniently, the input signal to the L(n-1) previously chosen noise shaping elements equals V(n) - K. The input signal to the M - L(n-1) other noise shaping elements equals V(n).

The value of constant K is chosen to guarantee that DAC 49 is stable. K desirably has the value of M ≤ K, and preferably M = K. M noise shaping elements 78 can be of at least first noise shaping order.

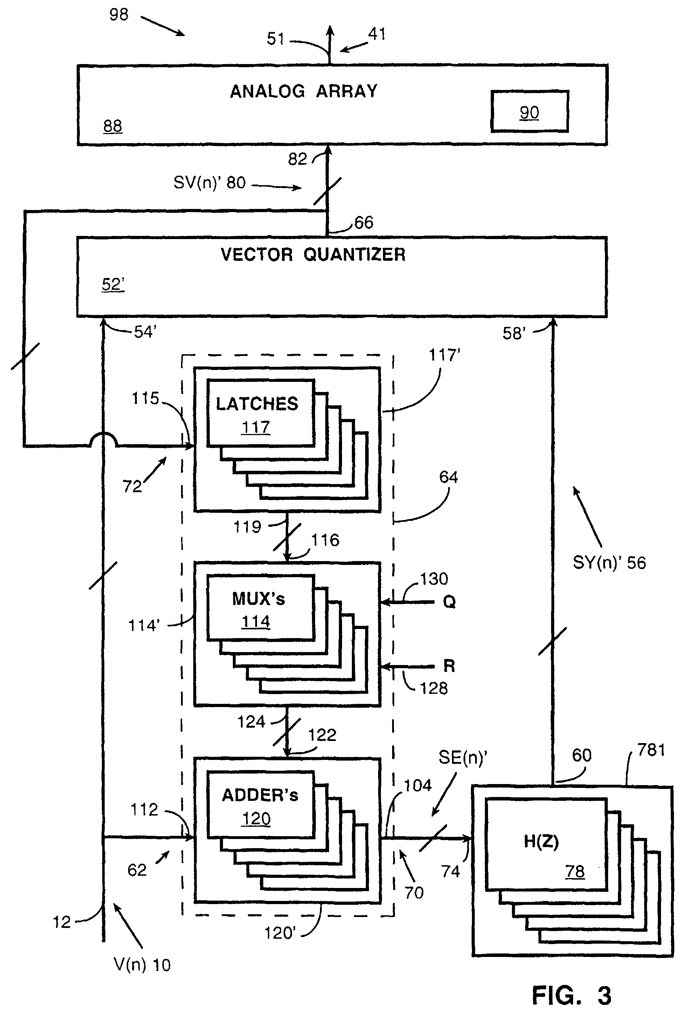

FIG. 3 is a schematic diagram of DAC 98, analogous to DAC 49 of FIG. 2, but showing greater detail. DAC 98 contains vector quantizer 52' analogous to vector quantizer 52, and M noise shaping elements 78 and analog array 88 with analog elements 90, as in FIG. 2. DAC 98 contains selection logic 64 (within dashed frame) comprising M multiplexers 114, M latches 117 and M adders 120. Vector quantizer 52' has M-bit input 54' for receiving digital input vector V(n) 10, and PxM-bit input 58' for receiving output SY(n)' 70 of noise shaping elements 78. Vector quantizer 52' has M-bit output 66 for providing signal SV(n)' 80 to analog array 88 to activate a selected subset of analog elements 90, in the same manner as previously described in connection with FIG. 2.

Vector quantizer 52' has M-bit output 66 coupled to M inputs 115 of M individual latches 117 (collectively 117'), analogous to input 72 of selection logic 64. M individual latches 117 have outputs 119 coupled to inputs 116 of individual multiplexers (e.g., MUX's) 114 (collectively 114'). Each of M multiplexers 114 has two data inputs 128, 130, one control input 116 and one N-bit output 124. Each output 124 of each MUX 114 is coupled to input 122 of individual adders 120 (collectively 120'). Each of M adders 120 has two inputs 122, 112, and one output 104. Inputs 112 are, collectively, analogous to input 62 of selection logic 64. Each of M noise shaping elements (collectively 78) has one N-bit input 74 and one P-bit output 60. The noise shaping elements are conveniently of first or higher order shaping, and preferably of second order shaping.

Each of M MUX's 114 has data inputs 128,130, coupled to sources of constants denoted, respectively, as "R" and "Q". The values of R and Q can be the same or different for each MUX 114. One of R or Q can be a reference potential or logic level, e.g., logical '0' or logical '1'. Either arrangement is useful. Preferably, "R" and "Q" can have as many as M bits each. In the preferred embodiment, "R" equals K and "Q" equals "0".

M outputs 124 of M MUX's 114 are coupled to M inputs 122 of M adders 112. M outputs 104 of M adders 112 are coupled to M inputs 74 of M noise shaping elements 78. M outputs 60 of M noise shaping elements 78 are coupled to inputs 58' of vector quantizer 52'.

Vector quantizer 52' selects the L(n) noise shaping elements that provide the highest output signal value and sends M-bit output signal SV'(n) 80, through M-bit output 66 which is received at M-bit inputs 82 of analog array 88. This signal SV'(n) 80 represents the L(n) noise shaping elements that were chosen and the M - L(n) noise shaping elements that were not chosen. This signal activates a subset G(n) of the available analog elements 90.

M latches 117 receive the vector SV'(n) from output 66 of vector quantizer 52. At the next cycle (i.e.- when a new input vector V(n+1) appears), SV'(n) is sent to the control inputs 116 of M multiplexers 114. The value of the input signal sent to inputs 116 of the L(n) multiplexers coupled to the L(n) previously chosen noise shaping elements is "1", resulting in an output signal value "R" appearing on output 124 of L(n) multiplexers.

The value of the input signal sent to inputs 116 of the M - L(n) multiplexers coupled to the M - L(n) noise shaping elements that were not chosen previously is "Q", resulting in an output signal value "Q" appearing in output 124 of M - L(n) multiplexers, e.g., having a value of logical 0 when Q = 0.

M adders 120 subtract the output signals of the M MUX's 124 from the input vector V(n+1) 10, and output the result to the M noise shaping elements 124. The input signal to the L(n) previously chosen noise shaping elements equals V(n+1) - R. The input signal to the M - L(n) other noise shaping elements equals V(n-1) - Q. Conveniently, the input signal to the L(n) previously chosen noise shaping elements equals V(n-1) - K. The input signal to the M - L(n) other noise shaping elements equals V(n+1).

The value of constant K is chosen to make the DAC stable. K conveniently has value of P ≤ R, and preferably P = R. As noted above, Q is preferably equal to logical zero.

For example, let M = 8, P = 12, R = K = 8, Q = 0, and H(Z1) > 0. Previous value of SV'(n) 80 (i.e.- SV'(n-1)) was (00101100)₂, indicating that the 3rd, 4th and 6th analog elements 90 were activated in the previous cycle (the subscript "2" indicates that this is a binary representation). SV'(n-1) is stored at 8 latches 117. In the current cycle, input vector V(n) 80 has a value (00001111)₂, indicating that four analog elements 90 are to be activated. Latch 117 outputs value (i.e. SV'(n-1)) equal to (00101100)₂, so that control input 116 of 3rd, 4th and 6th multiplexers 114 receive input signal of '1', causing these three multiplexers to select inputs 130 coupled to constant 8. Inputs 122 of the 3rd, 4th and 6th adders 120 receive an input signal having a value corresponding to input constant 8. These three adders 120 output signal V(n)' - 8 = 4 - 8 = - 4. Thus, the input signal to the 3rd, 4th and 6th noise shaping elements 78 has a value of -4. Control input 116 of the 1st, 2nd, 5th, 7th and 8th multiplexers 114 receive input signal of '0', causing these five multiplexers to select inputs 128 coupled to constant of value 0. The 1st, 2nd and 5th, 7th and 8th adders inputs 122 receive input signal of value 0. These five adders 120 output signal V(n)' - 0 = 4 - 0 = 4. Thus, the input signal to 1st, 2nd, 5th, 7th and 8th noise shaping elements 78 has a value of 4;

Input signals to eight noise shaping elements 78 are processed by 12-bit noise shaping elements 78, resulting in eight outputs values. Because input vector V(n)' 70 value is four, vector quantizer 52' chooses the four noise shaping elements 78 having the highest output values. If, for example, the outputs of the 1st, 3rd, 5th and 7th noise shaping elements have the highest values then vector SV'(n) = (01010101)₂, causing the 1st, 3rd, 5th and 7th analog elements in array 90 to be activated.

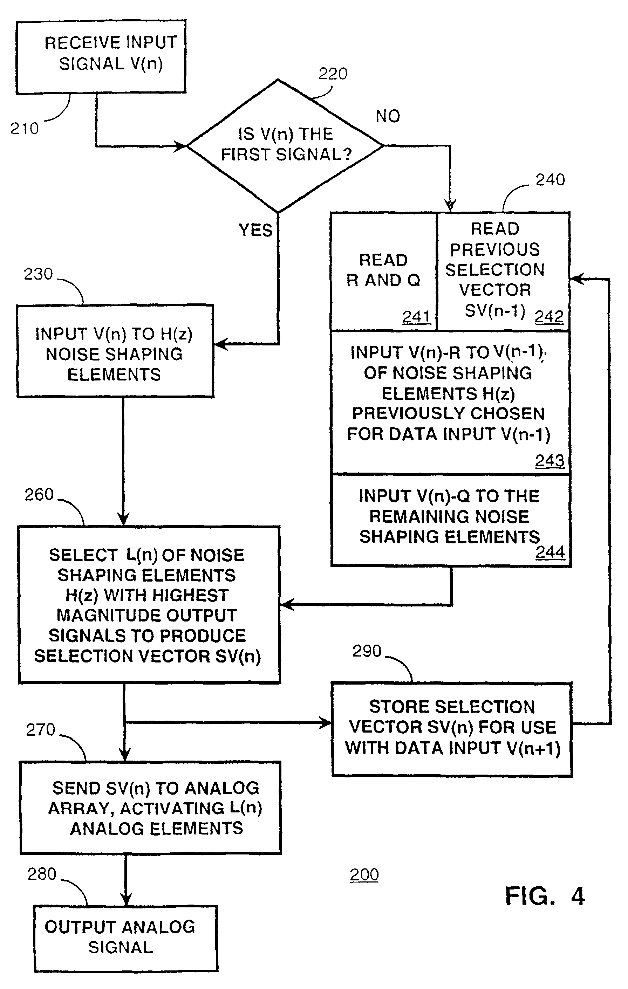

FIG. 4 is a flow diagram of method 200 for digital to analog conversion, according to a preferred embodiment of the present invention. In step 210, the system receives its first input, i.e., a digital M-bit vector V(n). The value of V(n), that is, the number of logical "1" bits out of M bits, is denoted as L(n) and can vary from 0 to M.

In step 220 DAC 49, 78 checks whether V(n) is the first input signal, and if it is so, then V(n) is input to M noise shaping elements in step 230. Otherwise, during step 240, an input signal of value of V(n) - R is input to the L(n-1) out of M noise shaping elements that were previously chosen, and an input signal of value of V(n) - Q is input to the remaining M - L(n-1) noise shaping elements that were not previously chosen. R preferably equals K and Q preferably equals 0. The content of the pervious selection vector SV(n-1) indicates which L(n-1) noise shaping elements were previously chosen. During step 260, the outputs of the M noise shaping elements are input to vector quantizer 52, 52' which selects the L(n) noise shaping elements having the highest output signal and produces a selection vector SV(n) which indicates which noise shaping elements are selected.

Those skilled in the art will appreciate that if H(z) has a bandwidth ranging from Z1 + dZ to Z1 - dZ (where, for example, Z1 = 0 for bandwidth around DC), then if H(Z1/2) > 0, vector quantizer 52, 52' selects the L(n) noise shaping elements that provide the highest output signal, and if H(Z1/2) < 0, then vector quantizer 52, 52' selects the L(n) noise shaping elements that provide the lowest output signal.

For example, if H(Z1) > 0 and V(n) = (0100001001)₂, then three noise shaping elements are to be chosen. If the output signals of the 2nd, 3rd, 4th noise shaping elements have the highest output signal then the selection vector equals (0000001110)₂. If, for example, V(n) = (1010011001)₂ then five noise shaping elements are chosen. If the output signals of the 10th, 8th, 7th, 4th and 1st noise shaping elements have the highest values then the selection vector equals (1011001001) ₂.

During step 270, selection vector SV(n) is sent to analog array 88, having M analog elements 90 so as to activate L(n) analog elements, according to the value of selection vector SV(n). In step 280, the analog output is provided which is proportional to the sum of the analog signals of the L(n) activated analog elements. In step 290, the selection vector SV(n) is stored for use in connection with the next input vector V(n+1).

Those skilled in the art will appreciate that the term "multiplexer" is a general description of a logic circuit that has two input values, such as for example "Q" and "R", one of which is transferred to the output of the multiplexer according to the value of a control input. Such a logic circuit can be implemented in many ways, as for example, by an AND logic gate, having two inputs, where one input is connected to the constant "R" and other input is connected to the output of the vector quantizer. The term "multiplexer" is intended to include any circuit means for accomplishing the selection among such inputs.

Those skilled in the art will also appreciate that the term "latch" is a general description of a logic circuit whose output signal equals a previous input signal, delayed in time. Latches can be implemented using various types of flip-flops (e.g., D, JK, SR, MR JK, MS SR), and can also be implemented by other logical elements, such as, but not limited to a RAM or a shift register, or combinations thereof. As used herein the term "latch" is intended to include these and other variations as will occur to those of skill in the art.

Having thus described the preferred embodiments of the disclosed invention, those skilled in the art will appreciate that further modifications, additions, changes and deletions may be made from these embodiments without departing from the spirit and scope of the invention as set forth in the following claims.

## Claims

1. A digital to analog converter (DAC) (49) for converting a multi-bit digital input signal into an analog output signal comprising:
M noise shaping elements (78);
a vector quantizer (52), coupled to the M noise shaping elements, wherein the vector quantizer reads a digital input vector V(n) (50), having value of L(n) and selects L(n) out of M noise shaping element output signals-having highest absolute values and which outputs a selection vector SV(n) containing the result of the selection;
an analog array (88), having M analog elements (90), coupled to the vector quantizer for receiving the selection vector SV(n), wherein the selection vector SV(n) activates L(n) out of the M analog elements, resulting in a analog output signal (41); and
selection logic (64), coupled to the vector quantizer and to the M noise shaping elements, wherein the selection logic reads the selection vector SV(n) wherein when a new input vector V(n+1) appears, the selection logic sends a first output signal to the L(n) previously selected noise shaping elements and sends a second output signal to the M -L(n) remaining noise shaping elements.

2. The DAC of claim 1 wherein the selection logic further reads two constants Q and R; wherein the value of the first output of the selection logic equals V(n) - R and the value of the second output signal of the selection logic equals V(n) - Q.

3. The DAC as set forth in claim 2, wherein R ≤ K, Q = 0.

4. The DAC as set forth in claim 2, wherein R = K, Q = 0.

5. The DAC as set forth in claim 1, wherein the analog output signal of the DAC is proportional to M.

6. The DAC as set forth in claim 1, wherein the selection logic (64) comprises:
M latches (114), coupled to the vector quantizer (52'), wherein the latches store selection vector SV(n-1);
M multiplexers (114), coupled to the latches, for selecting one out of two-output values, according to the selection vector SV(n-1) value; and
M adders (120), coupled to the M multiplexers and to the M noise shaping elements (78), wherein the M adders subtract the output signal of the M multiplexers from the input vector V(n), and send the result to the M noise shaping elements.

7. The DAC as set forth in claim 6 wherein the value of the first output signal of the selection logic equals V(n) - R and the value of the output signals of the selection logic equals V(n) - Q.

8. The DAC as set forth in claim 7, wherein R ≤ K, Q = 0.

9. The DAC as set forth in claim 7, wherein R = K, Q = 0.

10. The DAC as set forth in claim 6, wherein the analog output signal of the DAC is proportional to M.

11. A method for digital to analog conversion using M noise shaping elements, comprising the steps of:
receiving (210) an input signal V(n), having value L(n), wherein L(n) can vary from 0 to M;
checking (220) if the input signal V(n) is the first input signal and if so then inputting V(n) to M noise shaping elements, and if V(n) is not the first input signal;
reading (241) constants R and Q and reading a selection vector SV(n-1) corresponding to a prior input signal V(n-1);
inputting (243) V(n) - R to inputs of L(n-1) out of the M noise shaping elements where L(n-1) are the noise shaping elements chosen during processing of previous input signal V(n-1), and inputting (244) V(n) - Q to the inputs of remaining M - L(n-1) noise shaping elements not previously chosen during processing of input signal V(n-1);
receiving (260) the outputs of M noise shaping elements and selecting the L(n) noise shaping elements having the highest output magnitudes and producing a selection vector SV(n) which indicates which L(n) of the M noise shaping elements values were selected;
sending (270) the selection vector, to an analog array, having M analog elements so as to activate L(n) of the M analog elements; wherein each of the L(n) activated analog elements corresponds to the L(n) selected noise shaping elements.
outputting (280) an analog output signal proportional to the sum of the analog signals of the activated L(n) analog elements; and
storing (290) the selection vector SV(n).

12. The method as set forth in claim 11, wherein R ≤ K, Q = 0.

13. The method as set forth in claim 11, wherein R = K, Q = 0.

14. The method as set forth in claim 11, wherein the analog output signal of the DAC is proportional to M.

## Patentansprüche

1. Digital-Analog-Konverter (DAC)(49) zum Umwandeln eines digitalen Mehrfachbiteingangsignals in ein analoges Ausgangssignal, der umfasst:
M Rauschformgebungselemente (78);
einen Vektorquantisierer (52), der mit den M Rauschformgebungselementen verbunden ist, wobei der Vektorquantisierer einen digitalen Eingangsvektor V(n) (50) liest, der einen Wert von L(n) hat, und L(n) aus M Rauschformgebungselementausgangssignalen auswählt, die die höchsten absoluten Werte haben, und der einen Auswahlvektor SV(n) ausgibt, der das Ergebnis der Auswahl enthält;
ein analoges Array (88), das M analoge Elemente (90) hat und mit dem Vektorquantisierer zum Empfangen des Auswahlvektors SV(n) verbunden ist, wobei der Auswahlvektor SV(n) L(n) von den M analogen Elementen auswählt, was ein analoges Ausgangssignal (41) ergibt; und
eine Auswahllogik (64), die mit dem Vektorquantisierer und den M Rauschformgebungselementen verbunden ist, wobei die Auswahllogik den Auswahlvektor SV(n) liest, wobei, wenn ein neuer Eingangsvektor V(n+1) auftritt, die Auswahllogik ein erstes Ausgangssignal an die L(n) zuvor ausgewählten Rauschformgebungselemente sendet und ein zweites Ausgangssignal an die M - L(n) restlichen Rauschformgebungselemente sendet.

2. DAC gemäß Anspruch 1, bei dem die Auswahllogik weiterhin zwei Konstanten Q und R liest, wobei der Wert des ersten Ausgangs der Auswahllogik gleich V(n) - R ist und der Wert des zweiten Ausgangssignals der Auswahllogik gleich V(n)-Q ist.

3. DAC gemäß Anspruch 2, bei dem gilt R ≤ K, Q = 0.

4. DAC gemäß Anspruch 2, bei dem gilt R = K, Q = 0.

5. DAC gemäß Anspruch 1, bei dem das analoge Ausgangssignal des DAC proportional zu M ist.

6. DAC gemäß Anspruch 1, bei dem die Auswahllogik (64) folgendes umfasst:
M Verriegelungen beziehungsweise Latches (117), die mit dem Vektorquantisierer (52') verbunden sind, wobei die Latches den Auswahlvektor SV(n-1) speichern;
M Multiplexer (114), die mit den Latches verbunden sind, zum Auswählen eines von zwei Ausgangswerten entsprechend dem Wert des Auswahlvektors SV(n-1); und
M Addierer (120), die mit den M Multiplexern und den M Rauschformgebungselementen (78) verbunden sind, wobei die M Addierer das Ausgangssignal der M Multiplexer von dem Eingangsvektor V(n) subtrahieren und das Ergebnis an die M Rauschformgebungselemente senden.

7. DAC gemäß Anspruch 6, bei dem der Wert des ersten Ausgangssignals der Auswahllogik gleich V(n) - R ist und der Wert der Ausgangssignale der Auswahllogik gleich V(n) - Q ist.

8. DAC gemäß Anspruch 7, bei dem gilt R ≤ K, Q = 0.

9. DAC gemäß Anspruch 7, bei dem gilt R = K, Q = 0.

10. DAC gemäß Anspruch 6, bei dem das analoge Ausgangssignal des DAC proportional zu M ist.

11. Verfahren zur Digital-Analog-Umwandlung durch Verwenden von M Rauschformgebungselementen, das die folgenden Schritte umfasst:
Empfangen (210) eines Eingangssignals V(n), das den Wert L(n) hat, wobei L(n) von 0 bis M variieren kann;
Prüfen (220), ob das Eingangssignal V(n) das erste Eingangssignal ist, und wenn dies der Fall ist, Eingeben von V(n) in die M Rauschformgebungselemente, und wenn V(n) nicht das erste Eingangssignal ist;
Lesen (241) der Konstanten R und Q und Lesen eines Auswahlvektors SV(n-1) entsprechend eines vorherigen Eingangssignals V(n-1);
Eingeben (243) von V(n)-R in die Eingänge von L(n-1) der M Rauschformgebungselemente, wobei L(n-1) die Rauschformgebungselemente sind, die während der Verarbeitung des vorherigen Eingangssignals V(n-1) ausgewählt wurden, und Eingeben (244) von V(n)-Q in die Eingänge der restlichen M - L(n-1) Rauschformgebungselemente, die zuvor während der Verarbeitung des Eingangssignals V(n-1) nicht ausgewählt wurden;
Empfangen (260) der Ausgänge von M Rauschformgebungselementen und Auswählen der L(n) Rauschformgebungselemente, die die höchste Ausgangsgröße haben, und Herstellen eines Auswahlvektors SV(n), der anzeigt, welche L(n)-Werte der M Rauschformgebungselemente ausgewählt wurden;
Senden (270) des Auswahlvektors an ein analoges Array, das M analoge Elemente hat, um so L(n) der M analogen Elemente zu aktivieren, wobei jedes der L(n) aktivierten analogen Elemente den L(n) ausgewählten Rauschformgebungselementen entspricht.
Ausgeben (280) eines analogen Ausgangssignals, das proportional zu der Summe der analogen Signale der aktivierten L(n) analogen Elemente ist; und
Speichern (290) des Auswahlvektors SV(n).

12. Verfahren gemäß Anspruch 11, bei dem gilt R ≤ K, Q = 0.

13. Verfahren gemäß Anspruch 11, bei dem gilt R = K, Q = 0.

14. Verfahren gemäß Anspruch 11, bei dem das analoge Ausgangssignal des DAC proportional zu M ist.

## Revendications

1. Convertisseur numérique - analogique (CNA) (49) pour convertir un signal d'entrée numérique à plusieurs bits en un signal de sortie analogique, comprenant :
M éléments de mise en forme du bruit (78) ;
un quantificateur vectoriel (52) couplé aux M éléments de mise en forme du bruit, où le quantificateur vectoriel lit un vecteur d'entrée numérique V(n) (50) ayant une valeur L(n), sélectionne les L(n) signaux de sortie des M éléments de mise en forme du bruit qui ont les valeurs absolues les plus élevées, et émet un vecteur de sélection SV(n) contenant le résultat de la sélection ;
une matrice analogique (88), ayant M éléments analogiques (90), couplée au quantificateur vectoriel pour recevoir le vecteur de sélection SV(n), où le vecteur de sélection SV(n) active L(n) des M éléments analogiques, ce qui donne un signal de sortie analogique (41) ; et
une logique de sélection (64), couplée au quantificateur vectoriel et aux M éléments de mise en forme du bruit, où la logique de sélection lit le vecteur de sélection SV(n), de sorte que, lorsqu'un nouveau vecteur d'entrée V(n + 1) apparaît, la logique de sélection envoie un premier signal de sortie aux L(n) éléments de mise en forme du bruit précédemment sélectionnés et envoie un deuxième signal de sortie aux M - L(n) éléments de mise en forme de bruit restants.

2. CNA selon la revendication 1, dans lequel la logique de sélection lit, en outre, deux constantes Q et R ; où la valeur du premier signal de sortie de la logique de sélection est égale à V(n) - R et la valeur du deuxième signal de sortie de la logique de sélection est égale à V(n) - Q.

3. CNA selon la revendication 2, dans lequel R ≤ K, Q = 0.

4. CNA selon la revendication 2, dans lequel R = K, Q = 0.

5. CNA selon la revendication 1, dans lequel le signal de sortie analogique du CNA est proportionnel à M.

6. CNA selon la revendication 1, dans lequel la logique de sélection (64) comprend :
M verrous (117) couplés au quantificateur de vecteur (52'), où les verrous mémorisent un vecteur de sélection SV(n - 1) ;
M multiplexeurs (114) couplés aux verrous pour sélectionner l'une des deux valeurs de sortie en fonction de la valeur du vecteur de sélection SV(n - 1) ; et
M additionneurs (120) couplés aux M multiplexeurs et aux M éléments de mise en forme du bruit (78), où les M additionneurs soustraient le signal de sortie des M multiplexeurs au vecteur d'entrée V(n) et envoient le résultat aux M éléments de mise en forme du bruit.

7. CNA selon la revendication 6, dans lequel la valeur du premier signal de sortie de la logique de sélection est égale à V(n) - R et la valeur du deuxième signal de sortie de la logique de sélection est égale à V(n) - Q.

8. CNA selon la revendication 7, dans lequel R ≤ K, Q = 0.

9. CNA selon la revendication 7, dans lequel R = K, Q = 0.

10. CNA selon la revendication 6, dans lequel le signal de sortie analogique du CNA est proportionnel à M.

11. Procédé de conversion numérique - analogique utilisant M éléments de mise en forme du bruit, comprenant les étapes qui consistent à :
recevoir (210) un signal d'entrée V(n) ayant une valeur L(n), où L(n) peut varier de 0 à M ;
vérifier (220) si le signal d'entrée V(n) est le premier signal d'entrée et, si tel est le cas, envoyer V(n) aux M éléments de mise en forme du bruit, et, si V(n) n'est pas le premier signal d'entrée ;
lire (241) les constantes R et Q et lire un vecteur de sélection SV(n - 1) correspondant à un signal d'entrée précédent V(n - 1) ;
envoyer (243) la valeur V(n) - R aux entrées de L(n - 1) des M éléments de mise en forme du bruit, les L(n - 1) éléments de mise en forme du bruit étant ceux qui sont été choisis pendant le traitement du signal d'entrée précédent V(n - 1), et envoyer (244) la valeur V(n) - Q aux entrées des M - L(n - 1) éléments de mise en forme du bruit restants qui n'ont pas été précédemment choisis pendant le traitement du signal d'entrée V(n - 1) ;
recevoir (260) les signaux de sortie des M éléments de mise en forme de bruit, sélectionner les L(n) éléments de mise en forme du bruit ayant les signaux de sortie d'amplitudes les plus fortes, et produire un vecteur de sélection SV(n) qui indique quelles sont les L(n) des M valeurs d'éléments de mise en forme du bruit qui ont été sélectionnées ;
envoyer (270) le vecteur de sélection à une matrice analogique ayant M éléments analogiques, de façon à activer L(n) des M éléments analogiques ; où chacun des L(n) éléments analogiques activés correspond aux L(n) éléments de mise en forme du bruit sélectionnés ;
émettre (280) un signal de sortie analogique proportionnel à la somme des signaux analogiques des L(n) éléments analogiques activés ; et
mémoriser (290) le vecteur de sélection SV(n).

12. Procédé selon la revendication 11, dans lequel R ≤ K, Q = 0.

13. Procédé selon la revendication 11, dans lequel R = K, Q = 0.

14. Procédé selon la revendication 11, dans lequel le signal de sortie analogique du CNA est proportionnel à M.
